# EUROPÄISCHE PATENTSCHRIFT

(11) **EP 3 415 580 B1**
(45) Veröffentlichungstag und Bekanntmachung des Hinweises auf die Patenterteilung: **08.12.2021**
(21) Anmeldenummer: 18176923.3
(22) Anmeldetag: 11.06.2018
(51) Int. Cl.: C09J 7/38, H05H 1/48, H05H 1/24, B29C 59/14

(54) **VERFAHREN ZUR SIMULTANEN PLASMARANDVERKAPSELUNG VON MINDESTENS ZWEI KLEBEBANDSEITEN**
METHOD FOR SIMULTANEOUS PLASMA EDGE ENCAPSULATION OF AT LEAST TWO ADHESIVE STRIP SIDES
PROCÉDÉ D'ENCAPSULATION PAR PLASMA DE BORD SIMULTANÉE D'AU MOINS DEUX FACES DE BANDE ADHÉSIVE

(30) Priorität: 14.06.2017 DE 102017210066
(43) Veröffentlichungstag der Anmeldung: 19.12.2018
(73) Patentinhaber: tesa SE, 22848 Norderstedt (DE)
(72) Erfinder: Koops, Arne, 23881 Neu-Lankau (DE); Bendeich, Manuel, 22527 Hamburg (DE)
(74) Vertreter: tesa SE

(56) Entgegenhaltungen:
- EP-A1- 0 055 326
- WO-A1-2016/071232
- US-A1- 2002 131 182
- US-A1- 2016 329 191

## Beschreibung

Die Erfindung betrifft ein Verfahren zur Plasmabehandlung wenigstens einer Oberfläche. Die Erfindung betrifft auch eine Anordnung mit wenigstens einer Oberfläche und einer Vorrichtung zur Plasmabehandlung der wenigstens einen Oberfläche.

Bei Klebebandrollen, insbesondere des *ACX^{plus}* Sortiments der Firma *tesa* SE, hat es sich als nachteilig herausgestellt, dass die Klebebandseiten beim Stapeln oder bei Kontakt zu anderen Gegenständen zum Verkleben neigen. Um diesem unerwünschten Effekt entgegenzuwirken, werden typischerweise silikonisierte Seitenscheiben auf den Wickelspiegel der Rolle gelegt. Bei *ACX^{plus}* Produkten werden pro Rolle zur Sicherheit zwei Seitenscheiben eingesetzt, bei *filmic*-Produkten reicht nur eine Seitenscheibe. Selbige verhindern gleichzeitig eine Verschmutzung durch Partikel, die sich bei Transport oder Verarbeitung an den Haftklebstoff binden. Bei Einsatz entsprechender Seitenscheiben müssen diese passend auf Rollenmaß und Verpackung konfektioniert sein. Für eine maschinelle sowie manuelle Verarbeitung ist die Seitenscheibe anschließend zu entfernen, nach Gebrauch wiederum auf den Wickelspiegel zu legen. Insgesamt bedeutet die Nutzung silikonisierter Seiteneinleger einen nicht unerheblichen Arbeitsaufwand.

Es existieren bereits verschiedene Lösungen für die Deaktivierung der Klebebandseitenklebrigkeit.

Über eine Druckpuderbestäubung wird die Klebebandseite behandelt, so dass aufgetragenes Talkum oder aufgetragene Glaskugeln zu einer Reduzierung der Klebkraft führen. Nachteilig wirkt sich dieses Verfahren auf die optischen Eigenschaften der Klebebandrolle aus. Zudem kommt es zu einer Kontamination durch wenig fest haftende Talkumpartikel, was in zahlreichen Anwendungen unerwünscht ist. Eine Langzeitstabilität der Deaktivierung ist gleichzeitig nicht gegeben, da die aufgebrauchten Partikel bei höheren Temperaturen in die Klebmasse einsinken bzw. von dieser umflossen werden.

Als weitere Lösung wird die Beschichtung der Klebebandseite mit einem konventionellen Lack vorgenommen. Hier sind Prozesszeiten aufgrund der notwendigen Trocknung sehr lang. Gleichzeitig beobachtet man für große Auftragsmengen von z. B. 3 g/m² höhere Abrollkräfte. Durch Zugabe von Wasser in den Lack vermindert man die Filmbildung, so dass die Abrollkräfte auf normales Niveau reduziert werden können.

Aus der WO 2008/095653 A ist ein Verfahren zur Passivierung einer Kante von Haftklebebändern beschrieben, wobei die Passivierung durch physikalische oder chemische Vernetzung des Haftklebers auf der Kante oder durch den physikalischen oder chemischen Abbau der für die haftklebende Wirkung verantwortlichen Strukturen des Haftklebers erfolgt. Das wird durch Auftragen eines Vernetzers auf die Klebebandseite mit nachträglicher UV- oder IR-Bestrahlung, Elektronenbestrahlung, Gammabestrahlung oder Plasmabehandlung erzielt. Als Vernetzer werden unter anderem Epoxide, Amine, Isocyanate, Peroxide oder polyfunktionelle Silane offenbart. Nachteilig ist der relativ umständliche und aufwändige Aufbau des Verfahrens.

In der EP 1 373 423 ist ein Verfahren zum Deaktivieren der Klebeschicht der Kantenfläche einer Klebebandrolle beschrieben, bei dem strahlenchemisch vernetzbare Acrylate, Acrylatoligomere und Acrylatprepolymere aufgetragen werden und mit ionisierender und elektromagnetischer Strahlung ausgehärtet werden.

In der US 2010/004 47 530 ist ein Verfahren zur Beschichtung der Klebebandseiten einer Klebebandrolle beschrieben, bei dem ein indirektes Auftragsverfahren verwendet wird, bei dem strahlenhärtbare Lacke oder heißschmelzende Polymere zum Einsatz kommen.

In der EP 1 129 791 A2 ist ein Verfahren zur Herstellung von antiadhäsiven Beschichtungen beschrieben, bei denen die antiadhäsive Schicht mittels Niederdruckplasmapolymerisation auf das bahnförmige Material aufgebracht wird, indem das bahnförmige Material kontinuierlich durch eine Plasmazone gezogen geführt wird, in der ein Niederdruckplasma vorhanden ist. Die mittels Plasmapolymerisation geformten antiadhäsiven Beschichtungen sind insbesondere für Klebebandrückseiten und Trennmaterialien hergestellt.

Aus der US 2016/0329191 A1 ist ein Verfahren zur Verwendung einer Vorrichtung zur Oberflächenbehandlung und zur Beschichtung von Substraten bekannt. Das hierin offenbarte Behandlungssystem umfasst eine Plasmaquelle, die ein Atmosphärendruck-Plasma bereitstellt und eine Düse, die das erzeugte Plasma auf ein Werkstück richtet, welches der Austrittsöffnung der Düse gegenüberliegt, um diese mit dem Plasma zu behandeln. Das Werkstück hat dabei eine nicht-ebene Oberfläche.

In der EP 55326 A1 sind ein Verfahren und ein System zum Ablenken eines breiten lonenplasmastrahls beschrieben, um Halbleiter und Dünnschichtbauteile mit Plasma zu behandeln. Der elektrisch geladene lonenplasmastrahl wird bei diesem Verfahren durch eine elektrisch positiv geladene Ablenkfläche umgelenkt.

Aus der US 2002/0131182 A1 sind ein System und ein Verfahren zum Steuern einer Schichtdickenverteilung auf einem Substrat bekannt, um optische Filter herzustellen. Bei diesem Verfahren wird ein lonenstrahl auf ein Substrat geleitet welches drehbar in dem lonenstrahl angeordnet ist. Die Drehachse ist im Wesentlichen senkrecht zu der Abscheidungsfläche des Substrats.

Aus der WO2016 071 232 A1 ist ein Verfahren zur indirekten Plasmabehandlung einer Release-Schicht und eine plasmabehandelte Release-Schicht bekannt. Das Verfahren sieht vor, dass ein Plasmagas in einen Entladungsraum eingebracht und in einen angeregten Zustand versetzt wird, um es dann aus dem Entladungsraum auszublasen und die Release-Schicht dem ausgeblasenen Plasma auszusetzen.

Nachteilig an der direkten Plasmabehandlung von Klebebändern ist insbesondere, dass das Plasma hohe Temperaturen von 200 °C- 250 °C aufweist und sowohl die Klebmasseschicht als auch das Trägermaterial des Klebebandes einem thermischen Eintrag ausgesetzt sind, der diese zerstören kann.

Es ist daher Aufgabe der vorliegenden Erfindung, ein Verfahren und eine Anordnung zur Verfügung zu stellen, das bzw. die eine schonendere Plasmabehandlung von Oberflächen ermöglicht.

Die Aufgabe wird hinsichtlich des Verfahrens durch ein Verfahren mit den Merkmalen des Anspruchs 1 gelöst.

Erfindungsgemäß wird ein Plasmastrom aus einer Plasmadüse geführt, und die wenigstens eine Oberfläche wird außerhalb eines in Stromrichtung vorzugsweise gleichbleibend verlängerten Öffnungsquerschnitts der Plasmadüse angeordnet, und der Plasmastrom wird auf die wenigstens eine Oberfläche umgelenkt.

Die Oberfläche ist vorzugsweise eine Oberfläche einer Klebmasseschicht. Die Klebmasseschicht kann auf einer Trägerfolie aufgebracht sein, zusammen bilden sie das Klebeband aus. Das Klebeband kann natürlich noch mehr Schichten als die beiden genannten aufweisen.

Erfindungsgemäß wird die zu behandelnde wenigstens eine Oberfläche nicht direkt dem aus der Plasmadüse kommenden Plasmastrom ausgesetzt, sondern der Plasmastrom wird vorher umgelenkt. Der dann auf die wenigstens eine Oberfläche treffende umgelenkte Plasmastrom weist deutlich weniger thermische Energie auf als der direkt auf die wenigstens eine Oberfläche treffende Plasmastrom. Der umgelenkte Plasmastrom kann die wenigstens eine Oberfläche nicht mehr thermisch zerstören. Überraschenderweise hat sich gezeigt, dass die durch den Plasmastrom bewirkte Aktivierung der wenigstens einen Oberfläche erhalten bleibt, ebenso bleiben bei Zuführen eines Präkursors in den Plasmastrom auch nach dem Umlenken des Plasmastroms die Passivierungseigenschaften des Plasmastroms durch Aufbringen einer Passivierungsschicht auf die Oberfläche erhalten.

Durch Plasmabehandlungen können Oberflächen aktiviert werden, indem ein Prozessgas, das insbesondere auch Luft sein kann, durch ein elektrisches Feld angeregt und ionisiert wird und das angeregte Gas auf die Oberfläche geleitet wird.

Dem Prozessgas können Präkursoren, das sind insbesondere gasförmige Stoffe wie Siloxan, Acrylsäure oder Lösungsmittel, oder auch andere Bestandteile beigemischt werden. Präkursoren können eine Beschichtung der aktivierten Oberfläche bewirken.

Bei der Plasmabehandlung wird zwischen der direkten Coronar-Behandlung und der indirekten, eigentlichen Plasmabehandlung unterschieden. Eine Coronar-Behandlung ist als eine durch hohe Wechselspannung zwischen zwei Elektroden erzeugte Oberflächenbehandlung mit filamentären Entladungen definiert, wobei die diskreten Entladungskanäle auf die zu behandelnde Oberfläche treffen (siehe dazu auch Wagner et al., Vacuum71, 2003, S. 417-436. Als Prozessgas kann insbesondere Umgebungsluft verwendet werden. Bei der Corona-Behandlung ist das zu behandelnde Substrat, hier die zu behandelnde wenigstens eine Oberfläche, fast immer im Entladungsraum zwischen einer Elektrode und einer Gegenelektrode platziert oder hindurchgeführt, was als "direkt" für die physikalische Behandlung definiert ist. Bahnenförmige Substrate werden dabei typischerweise zwischen einer Elektrode und einer geerdeten Walze hindurchgeführt. Insbesondere in industriellen Anwendungen wird meist unter dem Begriff Corona die elektrische Barriereentladung verstanden. Dabei besteht mindestens eine der Elektroden aus einem Dielektrikum, also aus einem Isolator, oder ist mit einem solchen beschichtet oder überzogen. Insbesondere kann auch das Substrat hierbei als Dielektrikum fungieren. Daneben ist aber auch eine gleichmäßige, intensivere Corona-Behandlung von Materialen verschiedener Art, Form und Dicke möglich, bei dem der Corona-Effekt auf der Oberfläche des zu behandelnden Materials völlig vermieden wird. Beispielsweise ist in der EP 0497996 B1 eine Doppelstift-Elektrode gewählt, wobei für jede Stift-Elektrode ein eigener Kanal zur Druckbeaufschlagung vorhanden ist. Zwischen den beiden Spitzen der Elektroden steht eine Corona-Entladung, die den durch die Kanäle strömenden Gasstrom ionisiert und in ein Plasma umwandelt. Dieses Plasma gelangt dann an die zu behandelnde Oberfläche und führt dort insbesondere eine Oberflächenoxidation durch, welche die Benutzbarkeit der Oberfläche verbessert. Die Art der physikalischen Behandlung wird in unserem Zusammenhang als "indirekt" bezeichnet, weil die Behandlung nicht am Erzeugungsort der elektrischen Ladung vorgenommen wird. Im Weiteren wird vorzugsweise von einer indirekten Plasma-Corona-Behandlung ausgegangen, wenn von einer Plasmabehandlung gesprochen wird, dieses ist jedoch nicht notwendigerweise so. Vorzugsweise findet die Behandlung der Oberfläche bei oder nahe bei Atmosphärendruck statt, wobei jedoch der Druck zwischen Entladungsraum oder Gaskanal erhöht sein kann, insbesondere in den hier vorliegenden Fällen kann bei der Verwendung von Umgebungsluft als Prozessgas die Luft auch mit einem Druck von 5 bis 6 bar durch den Prozessgaskanal gedrückt werden. Durch die elektrischen Entladungen und durch lonisierungsprozesse im elektrischen Feld wird das Gas aktiviert und es werden hochangeregte Zustände in Gasbestandteilen erzeugt. Das verwendete Gas wird als Prozessgas bezeichnet. Wie oben bereits erwähnt, können dem Prozessgas auch Präkursoren beigemischt werden. Das Plasma bildet u. a. Elektronen und Ionen aus. Sie treffen auf die Oberfläche mit Energien, die ausreichen, um die meisten Molekülbindungen aufzubrechen. Die Reaktiviät der außerdem entstehenden reaktiven Gasbestandteile ist meistens ein untergeordneter Effekt. Die aufgebrochenen Bindungsstellen reagieren dann mit Bestandteilen der Luft oder des Prozessgases weiter, insbesondere können sie mit den Präkursoren weiterreagieren.

Die indirekte Plasmabehandlung unterscheidet sich von der Corona-Behandlung also insbesondere dadurch, dass bei der Plasmabehandlung keine direkte Einwirkung der Entladungskanäle auf der Oberfläche stattfindet. Die Wirkung findet also homogen und schonend, vor allem über reaktive Gasbestandteile statt. Bei einer indirekten Plasmabehandlung sind freie Elektronen möglicherweise vorhanden, aber eben nicht beschleunigt, da die Behandlung außerhalb des erzeugenden elektrischen Feldes stattfindet.

Das Plasmagerät der EP 0 497 996 B1 weist recht hohe Gasströme im Bereich von 36m³/Stunde auf, bei 40 cm Elektrodenbreite pro Spalt. Aus den hohen Strömungsgeschwindigkeiten resultiert eine geringe Verweilzeit der aktivierten Bestandteile auf der Oberfläche des Substrats. Des Weiteren gelangen auch nur solche Bestandteile des Plasmas zum Substrat, die entsprechend langlebig sind und durch einen Gasstrom bewegt werden können; Elektronen beispielsweise können nicht durch einen Gasstrom bewegt werden und spielen bei dieser Art der Plasmabehandlung keine Rolle.

Nachteilig bei der Plasmabehandlung ist jedoch die Tatsache, dass das auf die Substratoberfläche treffende Plasma hohe Temperaturen von im günstigsten Fall wenigstens 120° C aufweist, häufig besitzt das entsprechende Plasma jedoch hohe Temperaturen von einigen 100 ° C. Die bekannten Plasmadüsen führen zu einem hohen thermischen Eintrag in die wenigstens eine Oberfläche. Die hohen Temperaturen können zur Schädigung der Substratoberfläche führen, wodurch neben den aktivierenden ungewünschte Nebenprodukte entstehen, die als LMWOM (low molecular weight oxidized materials) bekannt sind. Dieser hochoxidierte und wasserlösliche Polymerschrott, der dem Substrat nicht mehr kovalent verbunden ist, wird zu einer geringen Resistenz gegenüber feucht-warmen Klimabedingung.

Überraschenderweise hat sich nun gezeigt, dass durch Umlenken eines aus einer Plasmadüse tretenden Plasmastroms eine Oberfläche plasmabehandelt, insbesondere durch Plasma aktiviert werden kann, wobei durch den größeren Abstand und die Umlenkung des Plasmastroms der Plasmastrom eine deutlich geringere Temperatur aufweist als in den Fällen, wo die zu behandelnde Oberfläche direkt unter die Plasmadüse, d. h. den Öffnungsquerschnitt der Plasmadüse angeordnet wird.

In einer bevorzugten Ausführungsform der Erfindung wird der aus der Öffnung tretende Plasmastrom an einer Prellfläche umgelenkt und auf eine Oberfläche gelenkt, die quer zur Querschnittsfläche der Öffnung angeordnet wird. Bei der Prellfläche kann es sich um eine horizontale, vorzugsweise metallische Fläche handeln, aber auch um eine kugelförmige, halbkugelförmige oder kugelsegmentförmige Fläche, auf die der Plasmastrom aus der Öffnung der Plasmadüse heraus auftrifft und durchaus auch in verschiedene Richtungen umgelenkt und geteilt werden kann. Die Prallkörper können auch aus anderen Materialen an ihrer Oberfläche, auf die der Plasmastrom trifft, bestehen. Ein Teil oder der gesamte umgelenkte Plasmastrom trifft dann auf die zu behandelnde wenigstens eine Oberfläche, die durch das Umlenken, das vorzugsweise in einem Winkel von 90° ± 10° geschieht, besonders bevorzugt ±5°, wobei aber auch jeder andere Winkel, insbesondere zwischen den Winkelangaben, vorgesehen sein kann und hiermit auch offenbart ist, quer, vorzugsweise ebenfalls senkrecht zur Querschnittsfläche der Öffnung angeordnet ist. Unter quer ist hierbei zu verstehen, dass die Querschnittsfläche der Öffnung eine Flächennormale aufweist und die wenigstens eine zu behandelnde Oberfläche ebenfalls eine Flächennormale aufweist. Die beiden Flächennormalen stehen jedoch nicht parallel zueinander, sondern in einem Winkel vorzugsweise senkrecht zueinander, sie können jedoch auch in einem Winkel von 90° ± 10°, besonders bevorzugt ± 5° zueinander stehen, wobei auch alle Zwischenwinkel mitoffenbart sind.

Besonders bevorzugt kann der Plasmastrom an einem Prallkörper geteilt werden und die Plasmastromteilungen gleichzeitig in verschiedene Richtungen umgelenkt werden, und jede der Plasmastromteilungen wird jeweils auf eine andere Oberfläche umgelenkt. Dadurch ist es möglich, mithilfe einer einzigen Plasmadüse gleichzeitig zwei Oberflächen oder jede höhere Anzahl an Oberflächen mit Plasma zu behandeln.

Besonders bevorzugt wird ein Klebeband mit einer Klebefläche und wenigstens einer, vorzugsweise zwei Klebebandseiten verwendet. Die beiden Klebebandseiten verlaufen sich gegenüberliegend entlang von zwei Klebeflächenrändern der Klebefläche. Vorzugsweise wird wenigstens eine der Klebebandseiten des Klebebandes als wenigstens eine Oberfläche verwendet, und die Klebebandseite wird senkrecht zur Querschnittsfläche der Öffnung angeordnet. Auch dabei kann die Klebebandseite des Klebebandes in anderen Winkelanordnungen, die oben genannt wurden, angeordnet werden.

Dieses Verfahren ist daher besonders günstig, weil es möglich ist, ein herkömmliches Klebeband mit einer Klebseite entlang einer, vorzugsweise jedoch beider Klebebandseiten mit Plasma zu behandeln und zu beschichten. Die Klebebandseiten werden somit passiviert, sie sind nach der Passivierung nicht mehr haftklebrig. Dazu wird die Klebseite des Klebebandes mit einem Liner abgedeckt, und das Klebeband wird parallel zum Öffnungsquerschnitt der Plasmadüse hindurchgezogen, aber erfindungsgemäß nicht direkt unterhalb der Plasmadüse, sondern neben der Plasmadüse entlangbewegt, vorzugsweise mit einer kontinuierlichen, gleichbleibenden Geschwindigkeit, und der aus der Plasmadüse austretende Plasmastrom wird an dem Prallkörper umgelenkt und trifft dann nur gegen die Klebebandseite des Klebebandes. Die Klebseite des Klebebandes wird, da sie durch den Liner abgedeckt ist, nicht plasmabehandelt. Die Plasmabehandlung der Klebebandseite ermöglicht es, die Klebkraft der Klebebandseite deutlich zu verringern, so dass ein später auf eine Rolle aufgewickeltes Klebeband einen nicht mehr klebrigen Wickelspiegel aufweist.

Es können gleichzeitig beide Klebebandseiten des Klebebandes mit Plasma behandelt werden, dazu kann der Plasmastrom geteilt werden, und die vorzugsweise zwei Teilströme können auf die beiden Klebebandseiten gelenkt werden.

Alternativ wird das Klebeband dazu zwischen zwei Plasmadüsen angeordnet, und jede der beiden Klebebandseiten wird jeweils außerhalb eines in Strömungsrichtung verlängerten Öffnungsquerschnitts einer zugeordneten Plasmadüse angeordnet. Es ist durch eine Anordnung einer Reihe von Plasmadüsen daher auch möglich, gleichzeitig eine Mehrzahl an Klebebändern zu passivieren, d. h. gleichzeitig beide Klebebandseiten mehrerer Klebebänder zu passivieren.

Besonders bevorzugt wird mit dem Plasmastrom eine Aktivierungsschicht auf die wenigstens eine Oberfläche, insbesondere auf die Klebebandseiten des Klebebandes aufgebracht. Vorzugsweise wird dem Plasmastrom ein organischer, polyfunktionelle Silane aufweisender Präkursor zugeführt. Der mit dem Präkursor angereicherte Plasmastrom wird auf wenigstens eine Oberfläche gerichtet und die wenigstens eine Oberfläche mit einer SiOx-Beschichtung überzogen. Erfindungsgemäß wird der Plasmastrom aber nicht direkt auf die wenigstens eine Klebebandseite gerichtet, sondern auf den Prallkörper, von dem der Plasmastrom abprallt und erst nach Umlenkung auf die wenigstens eine Oberfläche, insbesondere Klebebandseite, gelenkt wird. Auf die Klebebandseite wird vorzugsweise vollflächig eine SiOx-Beschichtung aufgebracht. Günstigerweise weist die Beschichtung eine über die gesamte Ausdehnung der Klebebandseite konstante Dicke auf, vorzugsweise ist die Beschichtung zwischen 60 nm bis 600 nm dick, vorzugsweise liegt die Dicke zwischen 100 nm und 200 nm. Als Präkursor wird günstigerweise Hexamethyldisiloxan (HMDSO) verwendet, das dem Prozessgas in einer Größenordnung von 10, 20, 40 bis 150 Gramm pro Stunde zugeführt wird. Das HMDSO wird in einem Verdampfer bei etwa 120 °C verdampft; das dem Verdampfer entweichende Präkursorgas wird einem Düsenkopf zugeführt und dort mit dem Prozessgas vermengt. Der Präkursor gelangt so mit dem Plasma auf die zu behandelnde Oberfläche. Statt HMDSO können jedoch auch (3-Glycidyloxypropyl)trimethoxysilane (GLYMO) und Octyltriethoxysilan (OCS) verwendet werden, vorzugsweise werden polyfunktionelle Silane verwendet.

Als Material für Trägerfolien eignen sich zum Beispiel PA, PU oder PVC, Polyolefine oder Polyester, vorzugsweise ein Polyester aus PET (Polyethylenterephthalat). Die Folie selbst kann wiederum aus mehreren einzelnen Lagen bestehen, beispielsweise aus zu Folie coextrudierten Lagen.

Bevorzugt werden Polyolefine verwendet, jedoch sind auch Copolymere aus Ethylen und polaren Monomeren wie Styrol, Vinylacetat, Methylmethacrylat, Butylacrylat oder Acrylsäure eingeschlossen. Es kann ein Homopolymer wie HDPE, LDPE, MDPE oder ein Copolymer aus Ethylen oder einem weiteren Olefin wie Propen, Buten, Hexen oder Octen (zum Beispiel LLDPE, VLDPE) sein. Geeignet sind auch Polypropylene (zum Beispiel Polypropylen-Homopolymere, Polypropylen-Random-Copolymere oder Polypropylen-Block-Copolymere).

Erfindungsgemäß hervorragend als Folien einsetzen lassen sich monoaxial und biaxial gereckte Folien. Monoaxial gerecktes Polypropylen beispielsweise zeichnet sich durch seine sehr hohe Reißfestigkeit und geringe Dehnung in Längsrichtung aus. Besonders bevorzugt sind Folien auf Basis von Polyester, insbesondere solche aus PET Polyethylenterephthalat.

Die Folie weist vorzugsweise eine Dicke von 12 µm bis 100 µm, weiter vorzugsweise von 28 bis 50 µm, insbesondere 35 µm auf.

Auf einer Seite der Trägerfolie ist eine vorzugsweise vollflächig die Seite der Trägerfolie abdeckende Klebmasseschicht vorgesehen. Es können alle bekannten Klebmassesysteme verwendet werden.

Neben natur- oder synthesekautschukbasierten Klebmassen sind insbesondere Silikonklebmassen sowie Polyacrylatklebmassen, vorzugsweise eine niedermolekulare Acrylatschmelzhaftklebmasse, verwendbar. Letztere sind in der DE 198 07 752 A1 sowie in der DE 100 11 788 A1 näher beschrieben.

Die eventuell vorhandene Laminierklebmasse kann aus den gleichen Klebmassesystemen gewählt werden.

Das Auftragsgewicht bewegt sich vorzugsweise im Bereich zwischen 15 bis 200 g/m², weiter vorzugsweise zwischen 30 bis 120 g/m², besonders bevorzugt bei 80 g/m² (das entspricht ungefähr einer Dicke von 15 bis 200 µm, weiter vorzugsweise von 30 bis 120 µm, besonders bevorzugt von 80 µm).

Vorzugsweise ist die Klebmasse eine Haftklebmasse, also eine viskoelastische Masse, die bei Raumtemperatur in trockenem Zustand permanent klebrig und klebfähig bleibt. Die Klebung erfolgt durch leichten Anpressdruck sofort auf fast allen Substraten.

Als Haftklebmassen finden solche auf Basis von Blockcopolymere enthaltenden Polymerblöcken Anwendung. Gebildet werden diese bevorzugt aus Vinylaromaten (A-Blöcke), wie zum Beispiel Styrol, und durch Polymerisation von 1,3-Dienen (B-Blöcke), wie zum Beispiel Butadien und Isopren, oder einem Copolymer aus beiden. Es können auch Mischungen unterschiedlicher Blockcopolymere zum Einsatz kommen. Bevorzugt werden Produkte eingesetzt, die zum Teil oder vollständig hydriert sind.

Die Blockcopolymere können eine lineare A-B-A-Struktur aufweisen. Einsetzbar sind ebenfalls Blockcopolymere von radialer Gestalt sowie sternförmige und lineare Multiblockcopolymere.

Anstelle der Polystyrolblöcke können auch Polymerblöcke auf Basis anderer aromatenhaltiger Homo- und Copolymere (bevorzugt C8- bis C12-Aromate) mit Glasübergangstemperaturen von > ca. 75 °C genutzt werden wie zum Beispiel α-methylstyrolhaltige Aromatenblöcke. Gleichfalls sind Polymerblöcke auf Basis von (Meth)acrylathomo- und (Meth)acrylatcopolymeren mit Glasübergangstemperaturen von > +75 °C nutzbar. Hierbei können sowohl Blockcopolymere zum Einsatz kommen, welche zum einen als Hartblöcke ausschließlich solche auf Basis von (Meth)acrylatpolymeren nutzen wie zum anderen auch solche, welche sowohl Polyaromatenblöcke, zum Beispiel Polystyrolblöcke, als auch Poly(meth)acrylatblöcke nutzen.

Die Angaben zur Glasübergangstemperatur für nicht anorganische und nicht überwiegend anorganische Materialien, insbesondere für organische und polymere Materialien, beziehen sich auf den Glasübergangstemperatur-Wert Tg nach DIN 53765:1994-03 (vgl. Abschnitt 2.2.1), sofern im Einzelfall nichts anderes angegeben ist.

Anstelle von Styrol-Butadien-Blockcopolymeren und Styrol-Isopren-Blockcopolymeren und/oder deren Hydrierungsprodukten, mithin Styrol-Ethylen/Butylen-Blockcopolymere und Styrol-Ethylen/Propylen-Blockcopolymere, können erfindungsgemäß ebenfalls Blockcopolymere und deren Hydrierungsprodukte genutzt werden, welche weitere polydienhaltige Elastomerblöcke nutzen wie zum Beispiel Copolymere mehrerer unterschiedlicher 1,3-Diene. Erfindungsgemäß nutzbar sind des Weiteren funktionalisierte Blockcopolymere wie zum Beispiel maleinsäureanhydridmodifizierte oder silanmodifizierte Styrolblockcopolymere.

Typische Einsatzkonzentrationen für das Blockcopolymer liegen in einer Konzentration im Bereich zwischen 30 Gew.-% und 70 Gew.-%, insbesondere im Bereich zwischen 35 Gew.-% und 55 Gew.-% vor.

Als weitere Polymere können solche auf Basis reiner Kohlenwasserstoffe wie zum Beispiel ungesättigte Polydiene wie natürliches oder synthetisch erzeugtes Polyisopren oder Polybutadien, chemisch im Wesentlichen gesättigte Elastomere wie zum Beispiel gesättigte Ethylen-Propylen-Copolymere, α-Olefincopolymere, Polyisobutylen, Butylkautschuk, Ethylen-Propylenkautschuk sowie chemisch funktionalisierte Kohlenwasserstoffe wie zum Beispiel halogenhaltige, acrylathaltige oder vinyletherhaltige Polyolefine vorhanden sein, welche die vinylaromatenhaltigen Blockcopolymere bis zur Hälfte ersetzen können.

Als Klebrigmacher dienen Klebharze.

Geeignete Klebharze sind unter anderem vorzugsweise partiell oder vollständig hydrierte Harze auf Basis von Kolophonium oder Kolophoniumderivaten. Es können auch zumindest zum Teil hydrierte Kohlenwasserstoffharze zum Beispiel hydrierte Kohlenwasserstoffharze, erhalten durch teilweise oder vollständige Hydrierung von aromatenhaltigen Kohlenwasserstoffharzen (zum Beispiel Arkon P und Arkon M Serien der Firma Arakawa oder Regalite-Serie von Eastman), Kohlenwasserstoffharze auf Basis von hydrierten Dicyclopentadien-Polymeren (zum Beispiel Escorez 5300er-Serie von Exxon), Kohlenwasserstoffharze auf Basis von hydrierten C5/C9-Harzen (Escorez 5600er-Serie von Exxon) oder Kohlenwasserstoffharze auf Basis von hydrierten C5-Harzen (Eastotac der Firma Eastman) beziehungsweise deren Gemische eingesetzt werden.

Auch hydrierte Polyterpenharze auf Basis von Polyterpenen sind verwendbar. Vorgenannte Klebharze können sowohl allein als auch im Gemisch eingesetzt werden.

Als weitere Additive können typischerweise Lichtschutzmittel wie zum Beispiel UV-Absorber, sterisch gehinderte Amine, Antiozonante, Metalldesaktivatoren, Verarbeitungshilfsmittel, endblockverstärkende Harze eingesetzt werden.

Plastifizierungsmittel wie zum Beispiel Flüssigharze, Weichmacheröle oder niedermolekulare flüssige Polymere wie zum Beispiel niedermolekulare Polyisobutylene mit Molmassen < 1500 g/mol (Zahlenmittel) oder flüssige EPDM-Typen werden typischerweise eingesetzt.

Die Erfindung wird in ihrem zweiten Aspekt durch eine eingangs genannte Anordnung mit den Merkmalen des Anspruchs 10 erfüllt.

Die Anordnung umfasst die wenigstens eine Oberfläche und eine Vorrichtung zur Passivierung der wenigstens einen Oberfläche. Die Vorrichtung zur Passivierung der wenigstens einen Oberfläche umfasst eine Plasmadüse mit einer Öffnung mit einem Öffnungsquerschnitt, wobei die wenigstens eine Oberfläche außerhalb eines in Strömungsrichtung verlängerten, vorzugsweise aber gleichbleibend großen Öffnungsquerschnitts der Plasmadüse angeordnet ist, und einen Prallkörper, der vor der Öffnung derart angeordnet ist, dass der Plasmastrom zumindest teilweise auf die wenigstens eine Oberfläche umgelenkt ist. Die erfindungsgemäße Anordnung eignet sich insbesondere zur Durchführung einer der oben genannten Verfahren, und die oben genannten Verfahren können mit der beschriebenen Anordnung durchgeführt werden.

Erfindungsgemäß kann eine herkömmliche Plasmadüse Bestandteil der Anordnung sein, wobei jedoch erfindungsgemäß die wenigstens eine Oberfläche, die mit dem aus der Plasmadüse tretenden Plasmastrom behandelt wird, nicht, wie in herkömmlicher Weise, direkt unter dem Öffnungsquerschnitt der Plasmadüse angeordnet ist, sondern neben dem Öffnungsquerschnitt. Wenn der vorzugsweise kreisförmige Öffnungsquerschnitt in Strömungsrichtung des Plasmas verlängert wird, also die Verlängerung günstigerweise einen zylindrischen Körper ausbildet, ist die zu behandelnde Oberfläche, insbesondere also die Klebebandseite eines Klebebandes, außerhalb dieses in Strömungsrichtung verlängerten Querschnitts der Plasmadüse angeordnet. Natürlich könnte der Öffnungsquerschnitt auch rechteckig sein und die Verlängerung damit quaderförmig. Es sind auch viele andere Formen des Öffnungsquerschnitts denkbar.

Der aus der Plasmadüse tretende Plasmastrom trifft die zu behandelnde Oberfläche nicht direkt, sondern erst nach Umlenkung. Vorzugsweise ist der Prallkörper so ausgebildet, dass er den Plasmastrom teilt und verschiedene Plasmastromteilungen auf unterschiedliche Oberflächen gerichtet sind. Der Prallkörper kann dazu insbesondere im Querschnitt senkrecht zur Strömungsrichtung des Plasmastroms dreieckig oder kugelförmig oder halbkreisförmig ausgebildet sein, der Prallkörper kann auch pyramidenförmig, tetraederförmig oder halbkugelförmig ausgebildet sein, so dass der auf den Prallkörper treffende Plasmastrom mit einem Durchmesser von vorzugsweise etwa 4 mm dem Durchmesser der Öffnung der Plasmadüse entspricht und je nach Auftreffpunkt in eine andere Richtung umgelenkt wird.

Die Erfindung wird anhand eines Ausführungsbeispiels in zwei Figuren beschrieben. Dabei zeigen:
- Fig. 1: eine Frontansicht einer erfindungsgemäßen Anordnung zur simultanen Passivierung von zwei Klebebandseiten,
- Fig. 2: eine perspektivische Ansicht der Anordnung in Fig. 1.

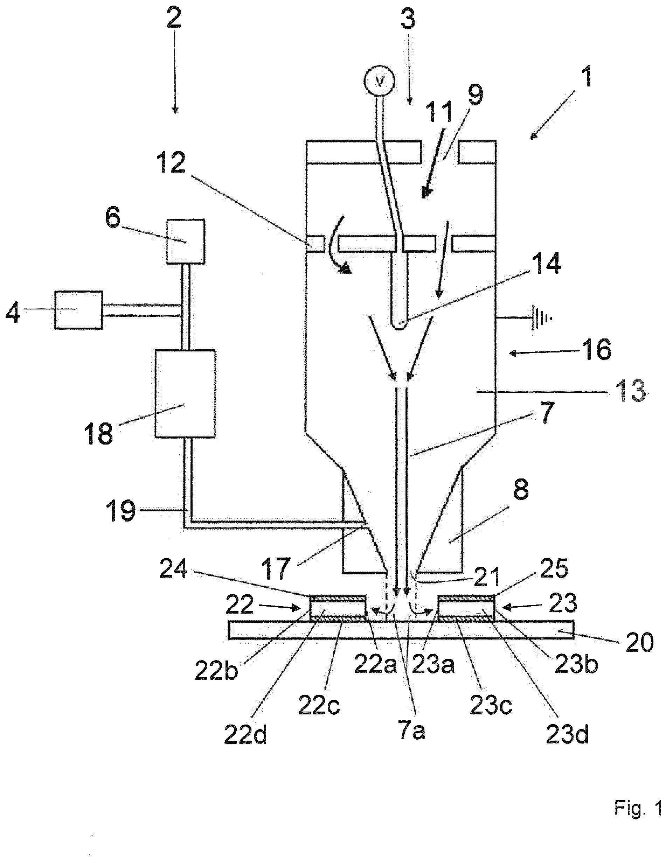

Fig. 1 zeigt eine Plasmadüse 1. Die Plasmadüse 1 umfasst eine Präkursoreinheit 2, die in Fig. 1 links dargestellt ist und eine Plasmaeinheit 3, die in Fig. 1 rechts dargestellt ist. Die Präkursoreinheit 2 erzeugt ein mit einem Präkursor 4 angereichertes Trägergas 6, während die Plasmaeinheit 3 ein Plasma 7 erzeugt. Der Präkursor 4 und das Plasma 7 werden in einem Düsenkopf 8 zusammengeführt.

Unter dem Plasma 7 wird hier ein hochenergetisches Prozessgas 11, insbesondere ionisierte Luft verstanden. Zur Erzeugung des Plasmas 7 wird zunächst der Plasmaeinheit 3 durch einen Einlass 9 das Prozessgas 11 zugeführt. Das Prozessgas 11 wird durch den Einlass 9 in die Plasmaeinheit 3 eingeleitet und gelangt durch eine Blende 12 mit Bohrungen in eine Entladungszone 13, durch die das Prozessgas 11 hindurchströmt. In der Entladungszone 13 wird das Prozessgas 11 an einer Elektrodenspitze 14 vorbeigeführt, an der eine hochfrequente Wechselspannung mit einigen Kilovolt und einer Frequenz von ca. 10 Kilohertz angeschlossen ist. Zwischen der Elektrodenspitze 14 und einer Gegenelektrode, die beispielsweise ein geerdetes Edelstahlgehäuse 16 sein kann, entsteht ein starkes elektrisches Wechselfeld, das zu einer sogenannten Corona-Entladung führt, die das durch die Plasmaeinheit 3 an der Elektrodenspitze 14 vorbeiströmende Prozessgas 11 ionisiert und in einen Plasmastrom 7a umwandelt. Das Plasma 7 wird durch den Düsenkopf 8 geführt, an dem an einem seitlichen Einlass 17 die Präkursoreinheit 2 angeschlossen ist. Der seitliche Einlass 17 des Düsenkopfes 8 ist mit der Präkursoreinheit 2 verbunden. Die Präkursoreinheit 2 umfasst eine erste Zufuhr für den Präkursor 4 und eine zweite Zufuhr für das Trägergas 6. Als Trägergas 6 kann hier ebenfalls Luft oder auch Stickstoff oder auch ein Gemisch aus Luft und Stickstoff verwendet werden. Der Präkursor 4 wird zerstäubt und dem Trägergas 6 tröpfchenförmig zugeführt. Das Gemisch gelangt in einen Verdampfer 18, wo Temperaturen oberhalb des Siedepunktes des Präkursors 4 herrschen. Als Präkursor 4 kann ein organisches, polyfunktionelles Silan verwendet werden, beispielsweise Octyltriethoxysilan (OCS), (3-Glycidyloxypropyl)trimethoxysilane (GLYMO) und Hexamethyldisiloxan (HMDSO).

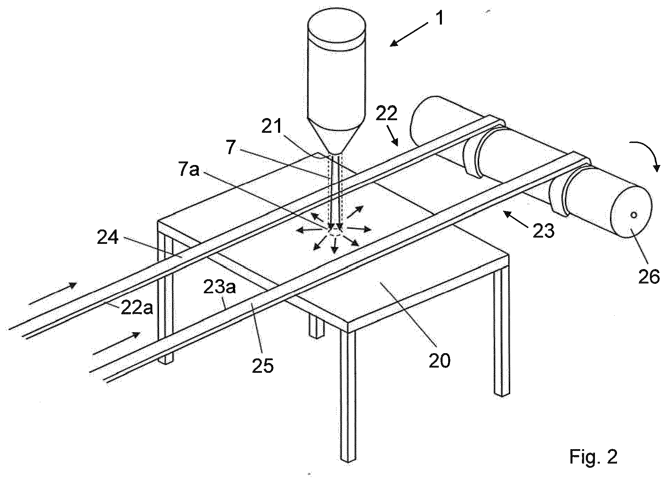

Bei dem hier verwendeten Präkursor 4 handelt es sich um Hexamethyldisiloxan (HMDSO), das dem Trägergas 6 in einer Größenordnung von 10, 20 oder 40 Gramm pro Stunde zugeführt wird. Die Temperatur im Verdampfer 18 liegt bei 120 °C, also oberhalb der Siedetemperatur von HMDSO, die etwa bei 100 °C liegt. Ein im Verdampfer 18 entweichende Präkursorgas 19 wird dem Düsenkopf 8 zugeführt und dort mit dem Plasma 7 vermengt, der Präkursor 4 gelangt so mit dem Plasma 7 aus der Plasmadüse 1 heraus und strömt auf einen Prallkörper 20. Der Prallkörper 20 ist hier als ebene Stahlplatte ausgebildet. An der Stahlplatte wird der Plasmastrom 7a mit dem beigemengten Präkursor 4 umgelenkt, insbesondere strömt das Plasma 7 seitlich entlang des Prallkörpers 20 weg. Eine Öffnung 21 der Plasmadüse 1 ist in einem Querschnitt senkrecht zur Stromrichtung des Plasmas 7 kreisförmig ausgebildet und weist einen Durchmesser von 4 mm auf. Eine Querschnittsfläche der Öffnung 21 ist horizontal angeordnet und parallel zur Prallfläche des Prallkörpers 20 angeordnet. Eine in Strömungsrichtung des Plasmas 7 verlängerte Querschnittsfläche der Plasmadüse 1 ist daher zylindrisch ausgebildet. Die verlängerte Querschnittsfläche ist in Fig. 1 und Fig. 2 durch gestrichelte Linien eingezeichnet.

Erfindungswesentlich ist hier, dass zwei parallel zueinander und voneinander beabstandet angeordnete Klebebänder 22, 23 vorgesehen sind, die seitlich neben der verlängerten Querschnittsfläche der Plasmadüse 1 angeordnet sind, d. h. der direkt aus der Öffnung 21 tretende Plasmastrom 7a trifft die Klebebänder 22, 23 nicht direkt, sondern innere Klebebandseiten 22a, 23a der beiden Klebebänder 22, 23 werden simultan von dem umgelenkten Plasmastrom 7a getroffen und passiviert. Äußere Klebebandseiten 22b, 23b der beiden Klebebänder 22, 23 werden in dieser Anordnung nicht passiviert.

Die beiden Klebebänder 22, 23 weisen jeweils eine Trägerfolie 22c, 23c auf sowie jeweils eine Klebmasseschicht 22d, 23d, die in Fig. 1 etwas dicker als üblich dargestellt ist. Eine Klebseite der Klebmasseschicht 22d, 23d, die später zur eigentlichen Verklebung verwendet wird, ist jeweils mit einem Liner 24, 25 abgedeckt; der Liner 24, 25 schützt die Klebseite des Klebebandes 22, 23 vor dem austretenden und umgelenkten Plasmastrom 7a. Dem umgelenkten Plasmastrom 7a sind somit nur die freiliegenden inneren Klebebandseiten 22a, 23a der beiden Klebebänder 22, 23 ausgesetzt.

Fig. 2 zeigt die Anordnung der Fig. 1 in einer perspektivischen Ansicht. Die beiden simultan behandelten Klebebänder 22, 23 werden auf einer Rolle 26 aufgewickelt und in gleichbleibender Geschwindigkeit über die Abprallfläche der Stahlplatte gezogen. Dabei sind die Klebebänder in Führungen, die hier nicht dargestellt sind, geführt, Abschnitte der inneren Klebebandseiten 22a, 23a der beiden Klebebänder 22, 23 werden während der gesamten Zeit simultan mit dem Plasmastrom 7a behandelt.

Jedes der beiden Klebebänder 22, 23 wird jeweils durch eine Trägerfolie 22c, 23c und eine Klebmasseschicht 22d, 23d gebildet. Die Trägerfolie 22c, 23c wird in unterschiedlichen Breiten zur Verfügung gestellt und in der zur Verfügung gestellten Breite mit der Klebmasseschicht 22d, 23d vollflächig beschichtet. Beim Aufwickeln des Klebebandes 22, 23 liegen die klebrigen Klebebandseiten 22a, 22b, 23a, 23b der Klebmasseschicht 22d, 23d des Klebebandes 22, 23 frei. Sie erschweren den Produkteinsatz, sie können verkleben und Fremdpartikel können sich an ihnen ablagern.

Die Haftklebrigkeit der inneren Klebebandseiten 22a, 23a wird durch Aufbringen einer Passivierungsschicht verringert, bei der Passivierungsschicht kann es sich um eine SiOx-Beschichtung handeln, die mit der in Fig. 1 und 2 dargestellten Plasmadüse 1 in einem Plasmaverfahren vollflächig auf die inneren Klebebandseiten 22a, 23a der Klebmasseschichten 22d, 23d des Klebebandes 22, 23 aufgebracht wird. Die Plasmadüse 1 steht dabei mit ihrem Öffnungsquerschnitt senkrecht zu den inneren Klebebandseiten 22a, 23a der Klebmasseschichten 22d, 23d.

Bei der Klebmasse kann es sich um einen Haftklebstoff, insbesondere einen Acrylklebstoff handeln. Bei der Substratbahn kann es sich um eine PET- oder PE-Folie handeln.

### Bezugszeichenliste

- 1: Plasmadüse
- 2: Präkursoreinheit
- 3: Plasmaeinheit
- 4: Präkursor
- 6: Trägergas
- 7: Plasma
- 7a: Plasmastrom
- 8: Düsenkopf
- 9: Einlass
- 11: Prozessgas
- 12: Blende
- 13: Entladungszone
- 14: Elektrodenspitze
- 16: geerdetes Edelstahlgehäuse
- 17: seitlicher Einlass
- 18: Verdampfer
- 19: Präkursorgas
- 20: Prallkörper
- 21: Öffnung
- 22: Klebeband
- 22a: innere Klebebandseite
- 22b: äußere Klebebandseite
- 22c: Trägerfolie
- 22d: Klebmasseschicht
- 23: Klebeband
- 23a: innere Klebebandseite
- 23b: äußere Klebebandseite
- 23c: Trägerfolie
- 23d: Klebmasseschicht
- 24: Liner
- 25: Liner
- 26: Rolle

## Patentansprüche

1. Verfahren zur Plasmabehandlung wenigstens einer Oberfläche, indem ein Plasmastrom (7a) aus einer Plasmadüse (1) geführt wird und
wenigstens eine Oberfläche außerhalb eines in Stromrichtung verlängerten Öffnungsquerschnitts einer Öffnung (21) der Plasmadüse (1) angeordnet wird und der Plasmastrom (7a) auf die wenigstens eine Oberfläche umgelenkt wird, **dadurch gekennzeichnet, dass** ein Klebeband (22, 23) mit einer Klebemasseschicht (22d, 23d) verwendet wird, das wenigstens eine Klebebandseite (22a, 22b, 23a, 23b) aufweist, die Klebebandseite (22a, 22b, 23a, 23b) senkrecht zur Querschnittsfläche der Öffnung (21) angeordnet wird und plasmabehandelt wird, wobei die wenigstens eine Oberfläche die wenigstens eine Klebebandseite (22a, 22b, 23a, 23b) ist.

2. Verfahren nach Anspruch 1,
**dadurch gekennzeichnet, dass** der aus der Öffnung (21) tretende Plasmastrom (7a) an einem Prallkörper (20) umgelenkt wird und die wenigstens eine Oberfläche quer zur Querschnittsfläche der Öffnung (21) angeordnet wird.

3. Verfahren nach Anspruch 1 oder 2,
**dadurch gekennzeichnet, dass** der Plasmastrom (7a) an einem Prallkörper (20) geteilt und die Plasmastromteilungen gleichzeitig in verschiedene Richtungen umgelenkt werden und jede der Plasmastromteilungen auf jeweils eine andere Oberfläche gelenkt wird.

4. Verfahren nach einem der Ansprüche 1, 2 oder 3,
**dadurch gekennzeichnet, dass** das Klebeband (22, 23) zwei Klebebandseiten (22a, 22b, 23a, 23b) aufweist, und die beiden Klebebandseiten (22a, 22b, 23a, 23b) gleichzeitig mit Plasma behandelt werden.

5. Verfahren nach einem der vorstehenden Ansprüche,
**dadurch gekennzeichnet, dass** das Klebeband (22, 23) mit zwei Klebebandseiten (22a, 22b, 23a, 23b) zwischen zwei Plasmadüsen (1) angeordnet wird und jede der beiden Klebebandseiten (22a, 22b, 23a, 23b) des Klebebandes (22, 23) jeweils außerhalb beider in Stromrichtung verlängerten Öffnungsquerschnitte der Plasmadüsen (1) angeordnet wird.

6. Verfahren nach einem der vorstehenden Ansprüche,
**dadurch gekennzeichnet, dass** die Klebebandseite (22a, 22b, 23a, 23b) haftklebrig ausgebildet wird und der Plasmastrom (7a) eine Passivierungsschicht auf die Klebebandseite (22a, 22b, 23a, 23b) aufbringt.

7. Verfahren nach einem der vorstehenden Ansprüche,
**dadurch gekennzeichnet, dass** das Klebeband (22, 23) mit einer Klebseite und zwei Klebebandseiten (22a, 22b, 23a, 23b) verwendet wird und eine Klebseite des Klebebandes abgedeckt wird und nur die Klebebandseiten (22a, 22b, 23a, 23b) passiviert werden.

8. Verfahren nach einem der vorstehenden Ansprüche,
**dadurch gekennzeichnet, dass** die wenigstens eine Oberfläche mit einer SiOx Beschichtung überzogen wird.

9. Anordnung mit wenigstens einer Oberfläche und einer Vorrichtung zur Plasmabehandlung der wenigstens einen Oberfläche mit
einer Plasmadüse (1) mit einer Öffnung (21) mit einem Öffnungsquerschnitt, wobei die wenigstens eine Oberfläche außerhalb eines in Strömungsrichtung verlängerten Öffnungsquerschnitts der Plasmadüse (1) angeordnet ist und
ein Prallkörper (20) vor der Öffnung (21) derart angeordnet ist, dass ein Plasmastrom (7a) zumindest teilweise auf die wenigstens eine Oberfläche umgelenkt ist, wobei ein Klebeband (22, 23) mit einer Klebemasseschicht (22d, 23d) verwendet wird, das wenigstens eine Klebebandseite (22a, 22b, 23a, 23b) aufweist, die Klebebandseite (22a, 22b, 23a, 23b) senkrecht zur Querschnittsfläche der Öffnung (21) angeordnet wird und plasmabehandelt wird, und wobei die wenigstens eine Oberfläche die wenigstens eine Klebebandseite (22a, 22b, 23a, 23b) ist.

10. Anordnung nach Anspruch 9,
**dadurch gekennzeichnet, dass** der Prallkörper (20) den Plasmastrom (7a) teilt und verschiedene Plasmastromteilungen auf unterschiedliche Oberflächen gerichtet sind.

11. Anordnung nach Anspruch 9 oder 10,
**dadurch gekennzeichnet, dass** die Öffnung (21) kreisförmig ausgebildet ist und einen Durchmesser von 4 mm aufweist.

## Claims

1. Method for the plasma treatment of at least one surface by a plasma stream (7a) being guided out of a plasma nozzle (1) and at least one surface being arranged outside an opening cross section of an opening (21) of the plasma nozzle (1) that is extended in the direction of the stream, and by the plasma stream (7a) being deflected onto the at least one surface, **characterized in that** an adhesive tape (22, 23) having an adhesive mass layer (22d, 23d) is used, which tape has at least one adhesive tape side (22a, 22b, 23a, 23b), which adhesive tape side (22a, 22b, 23a, 23b) is arranged perpendicularly to the cross-sectional region of the opening (21) and is plasma-treated, the at least one surface being the at least one adhesive tape side (22a, 22b, 23a, 23b).

2. Method according to claim 1,
**characterized in that** the plasma stream (7a) emerging from the opening (21) is deflected at an impact body (20) and the at least one surface is arranged transversely to the cross-sectional region of the opening (21).

3. Method according to either claim 1 or claim 2,
**characterized in that** the plasma stream (7a) is divided at an impact body (20) and the plasma stream divisions are deflected simultaneously in different directions and each of the plasma stream divisions is directed onto a different surface in each case.

4. Method according to any of claims 1, 2 or 3,
**characterized in that** the adhesive tape (22, 23) has two adhesive tape sides (22a, 22b, 23a, 23b), and the two adhesive tape sides (22a, 22b, 23a, 23b) are treated with plasma simultaneously.

5. Method according to any of the preceding claims,
**characterized in that** the adhesive tape (22, 23) having two adhesive tape sides (22a, 22b, 23a, 23b) is arranged between two plasma nozzles (1) and each of the two adhesive tape sides (22a, 22b, 23a, 23b) of the adhesive tape (22, 23) is, in each case, arranged outside both opening cross sections of the plasma nozzles (1) which are extended in the direction of the stream.

6. Method according to any of the preceding claims,
**characterized in that** the adhesive tape side (22a, 22b, 23a, 23b) is pressure-sensitive and the plasma stream (7a) applies a passivation layer to the adhesive tape side (22a, 22b, 23a, 23b).

7. Method according to any of the preceding claims,
**characterized in that** the adhesive tape (22, 23) having one adhesive side and two adhesive tape sides (22a, 22b, 23a, 23b) is used and one adhesive side of the adhesive tape is covered and only the adhesive tape sides (22a, 22b, 23a, 23b) are passivated.

8. Method according to any of the preceding claims,
**characterized in that** the at least one surface is coated with an SiOx coating.

9. Arrangement having at least one surface and a device for the plasma treatment of the at least one surface with a plasma nozzle (1) having an opening (21) with an opening cross section, wherein the at least one surface is arranged outside an opening cross section of the plasma nozzle (1) that is extended in the direction of the stream, and an impact body (20) is arranged in front of the opening (21) in such a way that a plasma stream (7a) is at least partially deflected onto the at least one surface, wherein an adhesive tape (22, 23) having an adhesive mass layer (22d, 23d) is used, which tape has at least one adhesive tape side (22a, 22b, 23a, 23b), which adhesive tape side (22a, 22b, 23a, 23b) is arranged perpendicularly to the cross-sectional region of the opening (21) and is plasma-treated, and wherein the at least one surface is the at least one adhesive tape side (22a, 22b, 23a, 23b).

10. Arrangement according to claim 9,
**characterized in that** the impact body (20) divides the plasma stream (7a) and different plasma stream divisions are directed onto different surfaces.

11. Arrangement according to either claim 9 or claim 10,
**characterized in that** the opening (21) is circular and has a diameter of 4 mm.

## Revendications

1. Procédé de traitement au plasma d'au moins une surface, dans lequel un flux de plasma (7a) est guidé hors d'une buse à plasma (1) et
au moins une surface est disposée à l'extérieur d'une section transversale d'ouverture, allongée dans le sens du flux, d'une ouverture (21) de la buse à plasma (1), et le flux de plasma (7a) est dévié sur l'au moins une surface, **caractérisé en ce qu'**un ruban adhésif (22, 23) comportant une couche de masse adhésive (22d, 23d) est utilisé, lequel ruban adhésif présente au moins un côté de ruban adhésif (22a, 22b, 23a, 23b), le côté de ruban adhésif (22a, 22b, 23a, 23b) est disposé perpendiculairement à la surface de section transversale de l'ouverture (21) et est traité au plasma, l'au moins une surface constituant l'au moins un côté de ruban adhésif (22a, 22b, 23a, 23b).

2. Procédé selon la revendication 1,
**caractérisé en ce que** le flux de plasma (7a) sortant de l'ouverture (21) est dévié vers un corps d'impact (20) et l'au moins une surface est disposée transversalement à la surface de section transversale de l'ouverture (21).

3. Procédé selon la revendication 1 ou 2,
**caractérisé en ce que** le flux de plasma (7a) est divisé sur un corps d'impact (20) et les divisions de flux de plasma sont déviées simultanément dans différentes directions et chaque division de flux de plasma est dirigée sur respectivement une autre surface.

4. Procédé selon l'une des revendications 1, 2 ou 3,
**caractérisé en ce que** le ruban adhésif (22, 23) présente deux côtés de ruban adhésif (22a, 22b, 23a, 23b) et les deux côtés de ruban adhésif (22a, 22b, 23a, 23b) sont traités au plasma de manière simultanée.

5. Procédé selon l'une des revendications précédentes,
**caractérisé en ce que** le ruban adhésif (22, 23) est disposé, avec deux côtés de ruban adhésif (22a, 22b, 23a, 23b), entre deux buses à plasma (1) et chaque côté de ruban adhésif (22a, 22b, 23a, 23b) du ruban adhésif (22, 23) est disposé respectivement à l'extérieur des deux sections transversales d'ouverture, allongées dans le sens du flux, des buses à plasma (1).

6. Procédé selon l'une des revendications précédentes,
**caractérisé en ce que** le côté de ruban adhésif (22a, 22b, 23a, 23b) est formé de façon adhésive et le flux de plasma (7a) applique une couche de passivation sur le côté de ruban adhésif (22a, 22b, 23a, 23b).

7. Procédé selon l'une des revendications précédentes,
**caractérisé en ce que** le ruban adhésif (22, 23) est utilisé avec un côté adhésif et deux côtés de ruban adhésif (22a, 22b, 23a, 23b) et un côté adhésif du ruban adhésif est recouvert et seuls les côtés de ruban adhésif (22a, 22b, 23a, 23b) sont passivés.

8. Procédé selon l'une des revendications précédentes,
**caractérisé en ce que** l'au moins une surface est recouverte d'un revêtement SiOx.

9. Agencement comportant au moins une surface et un dispositif de traitement au plasma de l'au moins une surface comportant une buse à plasma (1) comportant une ouverture (21) comportant une section transversale d'ouverture,
l'au moins une surface étant disposée à l'extérieur d'une section transversale d'ouverture, allongée dans le sens du flux, de la buse à plasma (1) et
un corps d'impact (20) étant disposé devant l'ouverture (21) de telle sorte qu'un flux de plasma (7a) est au moins partiellement dévié sur l'au moins une surface, un ruban adhésif (22, 23) comportant une couche de masse adhésive (22d, 23d) étant utilisé, lequel ruban adhésif présentant au moins un côté de ruban adhésif (22a, 22b, 23a, 23b), le côté de ruban adhésif (22a, 22b, 23a, 23b) étant disposé perpendiculairement à la surface de section transversale de l'ouverture (21) et étant traité au plasma, et l'au moins une surface constituant l'au moins un côté de ruban adhésif (22a, 22b, 23a, 23b).

10. Agencement selon la revendication 9,
**caractérisé en ce que** le corps d'impact (20) divise le flux de plasma (7a) et différentes divisions de flux de plasma sont dirigées vers différentes surfaces.

11. Agencement selon la revendication 9 ou 10,
**caractérisé en ce que** l'ouverture (21) est circulaire et présente un diamètre de 4 mm.
